# EUROPEAN PATENT APPLICATION

(11) **EP 3 435 424 A1**
(43) Date of publication of application: **30.01.2019**
(21) Application number: 17183569.7
(22) Date of filing: 27.07.2017
(51) Int. Cl.: H01L 31/0465, H01L 51/42

(54) **A PHOTOVOLTAIC PANEL AND METHOD OF MANUFACTURING THE SAME**

(71) Applicant: Nederlandse Organisatie voor toegepast- natuurwetenschappelijk onderzoek TNO, 2595 DA 's-Gravenhage (NL)
(72) Inventor: Lifka, Herbert, 2595 DA 's-Gravenhage (NL)
(74) Representative: V.O.

(57) **Abstract**

A photovoltaic panel (1) is provided, comprising in the order named, a first electrically conductive layer (10), a photovoltaic layer (30) of a perovskite photovoltaic material, a second electrically conductive layer (20), and a protective coating (40) that at least forms a barrier against moisture.

The first electrically conductive layer (10) is partitioned along first partitioning lines (L11, L12) extending in a first direction (D1). The second electrically conductive layer (30) and the photovoltaic layer (20) are partitioned along second partitioning lines (L21, L22) extending in the first direction (D1) and along third partitioning lines (L31, L32) extending in a second direction (D2) different from the first direction (D1). The first and the second partitioning lines alternate each other and a space (50) is defined by the first and third partitioning lines that is filled with a protective filler material forming a barrier against moisture, therewith defining photovoltaic cells encapsulated by the protective material of the coating and the protective filler material.

## Description

### BACKGROUND OF THE INVENTION

### Field of the invention

The present invention pertains to a photovoltaic panel.

The present invention further pertains to a method of manufacturing a photovoltaic panel.

### Related Art

Perovskites, are promising materials for use as a photovoltaic material in a photovoltaic layer of a photovoltaic panel. The name 'perovskites' is used to denote materials having an ABX3 crystal structure. The most commonly studied perovskite for photovoltaic cells is methylammonium lead trihalide (CH3NH3PbX3, where X is a halogen atom such as iodine, bromine or chlorine), with an optical bandgap between 1.5 and 2.3 eV depending on halide content. Another example is formamidinum lead trihalide (H2NCHNH2PbX3) having bandgaps between 1.5 and 2.2 eV. So far it has not been possible to find suitable alternatives for the component lead. Tin-based perovskite photovoltaic materials such as CH3NH3SnI3 have also been investigated. Probably these Tin based perovskite will in the future , be combined with Lead based perovskites, either in mixtures or as separate layers in a tandem or even triple configuration. A common concern is that lead and also Tin as a component of the perovskite materials may enter the environment in case defects are present in the panel.

### SUMMARY

It is an object of the invention to provide a photovoltaic panel having a construction that mitigates the risk that lead and or tin present in the photovoltaic layer enters the environment.

It is a further object of the invention to provide a method of manufacturing such a photovoltaic panel.

A photovoltaic panel according to the object specified above, is provided as defined in claim 1. The photovoltaic panel as claimed therein comprises in the order named a first electrically conductive layer, a photovoltaic layer of a perovskite photovoltaic material, a second electrically conductive layer, and a protective coating that at least forms a barrier against moisture. It is noted that any of these layers may be one of a stack of similar layers. Therein the individual layers in the stack of similar layers may be formed of mutually different materials and have mutually different properties. For example, the first /second electrically conductive layer may be one of a stack of first/second electrically conductive layers. The photovoltaic layer of a perovskite photovoltaic material may be one of a stack of photovoltaic layers of a perovskite photovoltaic material. Individual layers in the stack of photovoltaic layers may be formed of a respective material, for example of perovskite photovoltaic materials of mutually different types or of mutually different compositions of perovskite photovoltaic materials. For example two or three or more of such photovoltaic layers may be provided. A stack of one or more photovoltaic layers of a perovskite photovoltaic material may further comprise one or more layers of another photovoltaic material. The protective coating may also be provided as a stack of layers, for example a stack of inorganic layers of a different type alternating each other, for example of mutually different ceramic materials that alternate each other. In addition to the above-mentioned layers other layers may be present, for example one or more hole injection layers, one or more hole transport layers, one or more electron injection layer and/or one or more electron transport layers. The first electrically conductive layer of the photovoltaic panel is partitioned along first partitioning lines extending in a first direction. In case the first electrically conductive layer is one of a stack of similar layers, then all layers of this stack are partitioned along these first partitioning lines. This also applies to any other electrically conductive layers, such as hole/electron injection/transport layers between the first electrically conductive layer and the photovoltaic layer. Furthermore, the second electrically conductive layer and the photovoltaic layer are partitioned along second partitioning lines extending in the first direction and along third partitioning lines extending in a second direction different from the first direction. In case the second electrically conductive layer is one of a stack of similar layers, then all layers of this stack are partitioned along these second partitioning lines and third partitioning lines. This also applies to any other electrically conductive layers, such as hole/electron injection/transport layers between the second electrically conductive layer and the photovoltaic layer. Likewise, if the photovoltaic layer is one of a stack of layers then all layers of this latter stack are partitioned along these second partitioning lines and third partitioning lines. The first and the second partitioning lines alternate each other and a space defined by the first and the third partitioning lines is filled with a protective filler material forming a barrier against moisture. Therewith photovoltaic cells are defined that are encapsulated by the protective material of the coating and the protective filler material.

In addition to the above-mentioned sets of partitioning lines, further partitioning lines may be provided at oblique angles with respect to the earlier mentioned partitioning lines that partition the top layers of the photovoltaic panel into triangular portions, for example up to but not including the bottom electrode. This additional partitioning facilitates folding the photovoltaic panel in a three dimensional shape. The spaces formed between the triangular portions may be filled with a protective material. If necessary additional conductive elements may be provided to electrically interconnect mutually separate portions.

The encapsulation of the perovskite photovoltaic material in photovoltaic cells substantially limits an amount of the photovoltaic material that could enter the environment in case of a defect. The protective material is part of an encapsulation that encapsulates the first electrically conductive layer, the second electrically conductive layer and the photovoltaic layer. The encapsulation forms a barrier against moisture, therewith effectively protecting against an ingress of moisture that in contact with the photovoltaic layer would result in a degradation of the latter.

The encapsulation may for example additionally comprise a substrate of the panel. If the substrate as such does not form a sufficiently effective barrier for moisture, it may be provided with additional barrier layer. In an embodiment the first electrically conductive layer may serve as a substrate. Alternatively, the first electrically conductive layer may be a layer on a substrate.

A method according to the further object is clamed in claim 9. The method of manufacturing a photovoltaic panel subsequently comprises:
Providing a first electrically conductive layer that is partitioned along first partitioning lines extending in a first direction;
Providing at least one photovoltaic layer of a perovskite photovoltaic material, the at least one photovoltaic layer being partitioned along second partitioning lines extending in the first direction;
Providing a second electrically conductive layer that electrically contacts the first electrically conductive layer along fourth lines in the first direction;
Providing a protective material into spaces defined by second partitioning lines extending in the first direction, and by third partitioning lines extending in a second direction different from the first direction and which spaces partition the second electrically conductive layer and the photovoltaic layer wherein respective ones of the fourth lines are arranged between respective ones of the first partitioning lines and a respective nearest one of the second partitioning lines;
Providing a protective material as a protective coating layer therewith providing a plurality of photovoltaic cells having a respective encapsulated portion of the photovoltaic layer.

An embodiment of the method may further comprise the step of inspecting individual photovoltaic cells of the plurality of photovoltaic cells. Upon detection of a defect of one of the individual photovoltaic cells, the photovoltaic material contained in the defect cell may be removed. Therewith it also is avoided that photovoltaic material in the defect photovoltaic cell can enter the environment.

The photovoltaic panel obtained therewith is characterized in that it comprises a space free from photovoltaic material that is bounded by a wall of protective material to an area defined by a pair of mutually subsequent first partitioning lines and a pair of mutually subsequent third partitioning lines.

As an alternative, upon detection of defects, it may be decided to withdraw the defect product from the production line, for example in case it is detected that the product comprises more than a predetermined number of defects, for example if more than one defect occurs in a serial arranged subset of the photovoltaic cells.

As noted above, a layer may comprise two or more sublayers. For example the photovoltaic layer may be provided as a bilayer of a p-type and an n-type organic material and/or as sublayers sensitive for mutually different ranges of the solar spectrum. Also an electrode layer may further be provided as two or more layers, for example a first sublayer serving as a bulk layer and a second sublayer serving to provide a desired workfunction.

In addition further layers and other elements may be present in the photovoltaic plane, for example a hole injection layer, an electron injection layer, electric insulation layers, a mechanical support layer, electrically conductive elements, sensor elements e.g. for diagnostic purposes and the like.

In an embodiment, the photovoltaic panel comprises a planarizing layer, e.g. a resin layer having a thickness in the range of 0.1 to 100 micron, between the second electrically conductive layer and the protective coating. Therewith the encapsulation properties of the protective coating are improved.

For an optimal sealing, this planarizing layer is provided preferably in a manufacturing process preferably before the (laser) structuring of the second electrodes to ensure the good sealing of the elements.

As becomes apparent from the description the wording "line" is not intended in the purely mathematical sense of a geometrical object having only a length and no other dimensions, but as an interruption in the material having a length and a finite two-dimensional cross-section with dimensions that are substantially smaller than its length, e.g. at most 0.01 times its length.

### BRIEF DESCRIPTION OF THE DRAWINGS

These and other aspects are described in more detail with reference to the drawing. Therein:
FIG. 1, 1A, 1B show a first embodiment of a photovoltaic panel according to the first object; therein FIG. 1 shows a top-view and FIG. 1A and 1B respectively show a cross-section according to IA-IA and IB-IB in FIG. 1;
FIG. 2, 2A, 2B show a second embodiment of a photovoltaic panel according to the first object; therein FIG. 2 shows a top-view and FIG. 2A and 2B respectively show a cross-section according to IIA-IIA and IIB-IIB in FIG. 2;

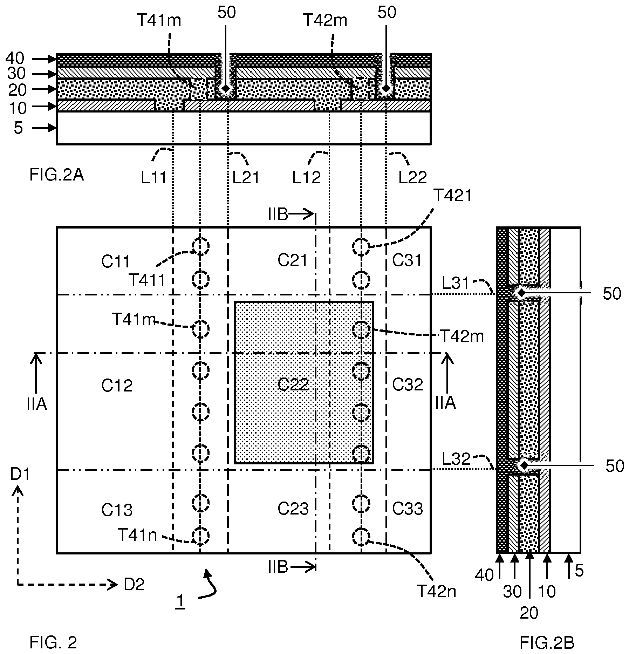

FIG. 2, 2A, 2B show a second embodiment of a photovoltaic panel according to the first object; therein FIG. 2 shows a top-view and FIG. 2A and 2B respectively show a cross-section according to IIA-IIA and IIB-IIB in FIG. 2;

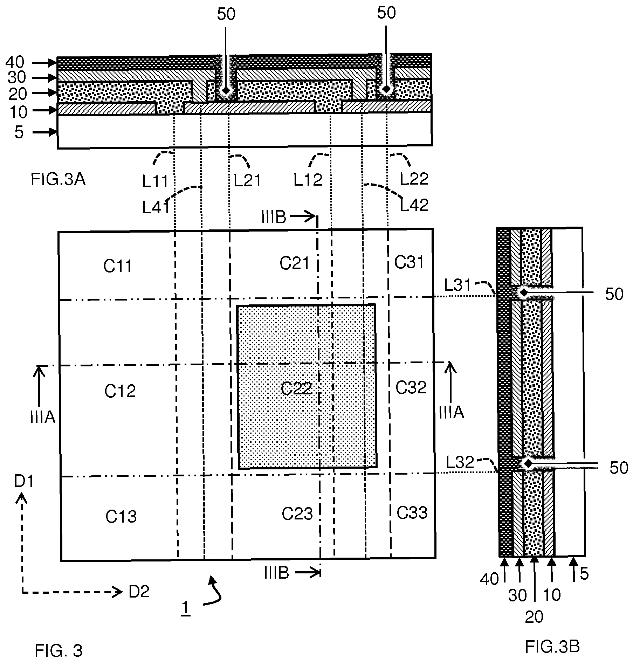

FIG. 3, 3A, 3B show a third embodiment of a photovoltaic panel according to the first object; therein FIG. 3 shows a top-view and FIG. 3A and 3B respectively show a cross-section according to IIIA-IIIA and IIIB-IIIB in FIG. 3;

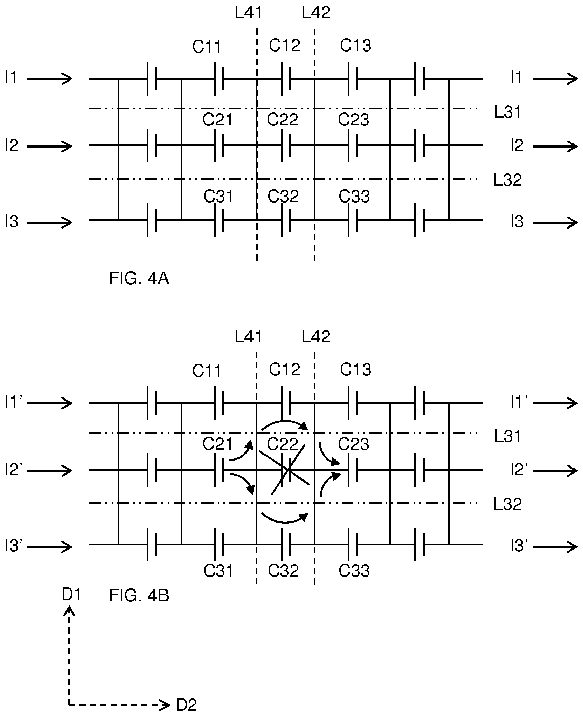

FIG. 4A, 4B show an electric replacement scheme of a photovoltaic panel according to the first or the second embodiment; therein FIG, 4A shows a version wherein all photovoltaic cells are operational and FIG. 4B shows a version wherein one of the photovoltaic cells is defect;

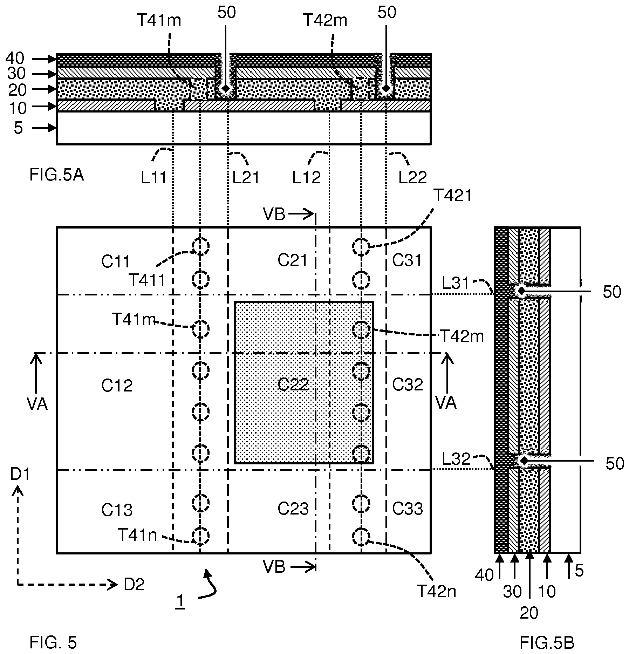

FIG. 5, 5A, 5B show a fourth embodiment of a photovoltaic panel according to the first object; therein FIG. 5 shows a top-view and FIG. 5A and 5B respectively show a cross-section according to VA-VA and VB-VB in FIG. 5;

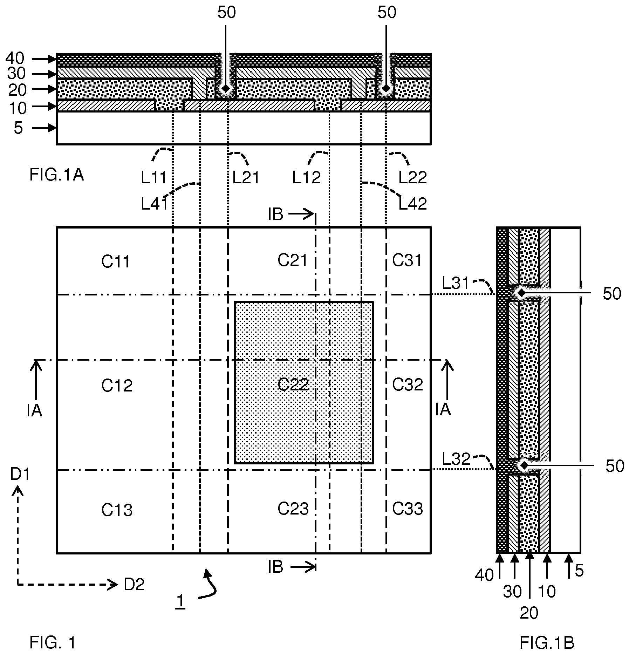

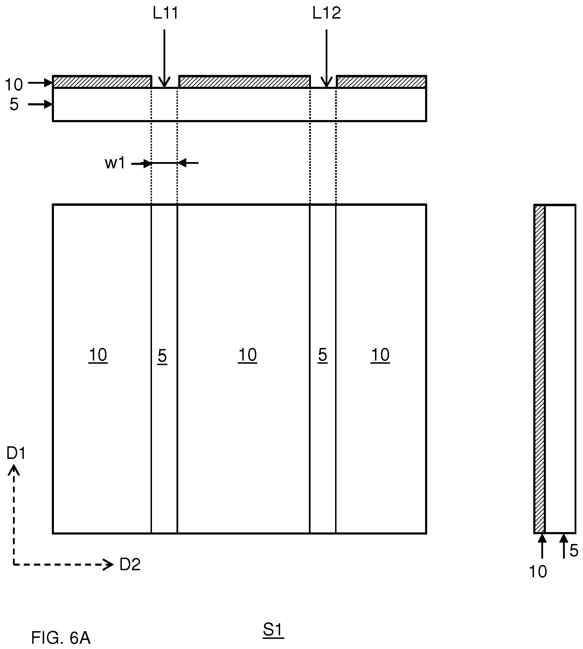

FIG. 6A-6F shows subsequent steps in a manufacturing method according to the further object, in each of FIG. 6A-6F three views of the (semi-finished) product are shown analogous to the views shown for example in FIG. 1, 1A, 1B, i.e. in the center of the figure a top-view is shown as in FIG. 1, on top of this view a cross-section is shown as in FIG. 1A and on the right thereof a cross-section is shown as in FIG. 1B, in FIG. 6A-6F:
FIG. 6A shows a first step S1 of the manufacturing method,

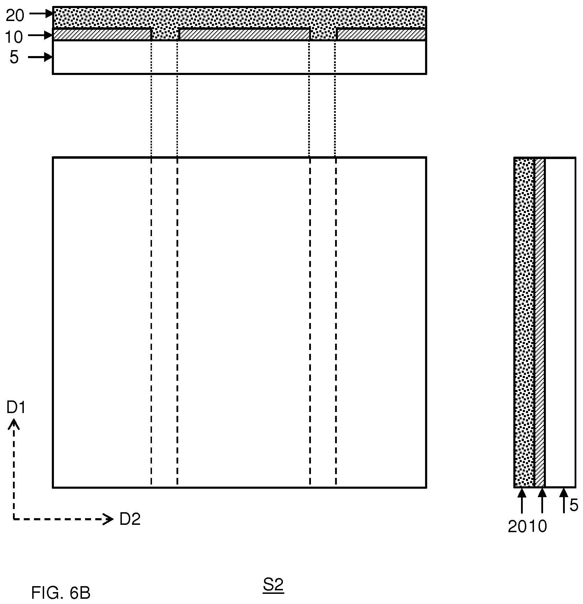

FIG. 6B shows a second step S2 of the manufacturing method,

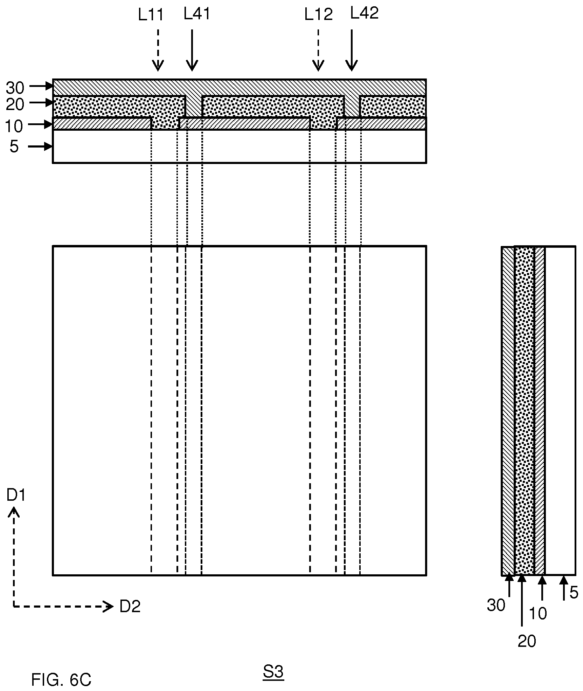

FIG. 6C shows a third step S3 of the manufacturing method,

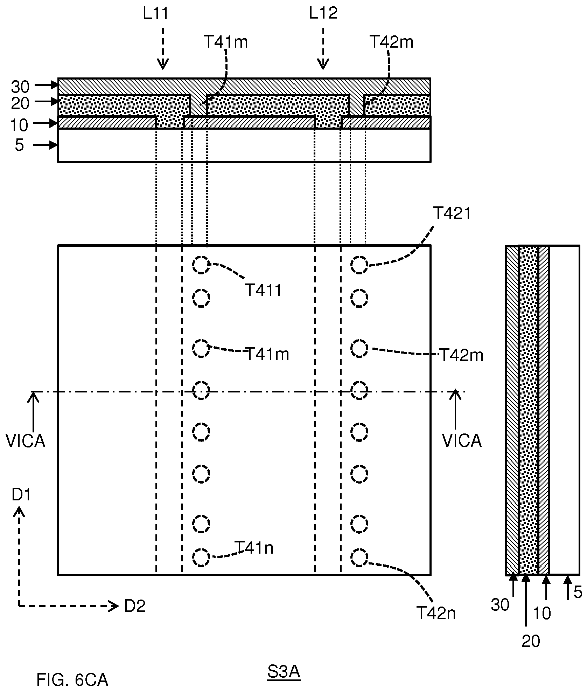

FIG. 6CA shows an alternative third step S3A of the manufacturing method,

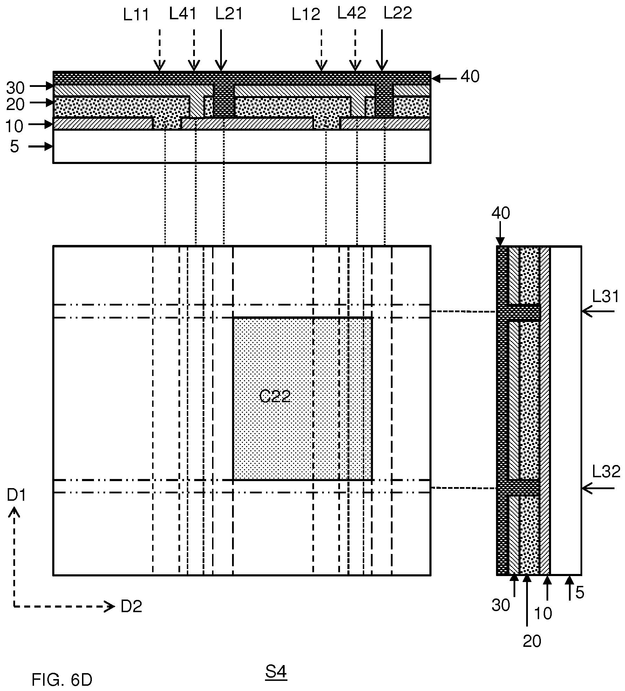

FIG. 6D shows a fourth step S4 of the manufacturing method,

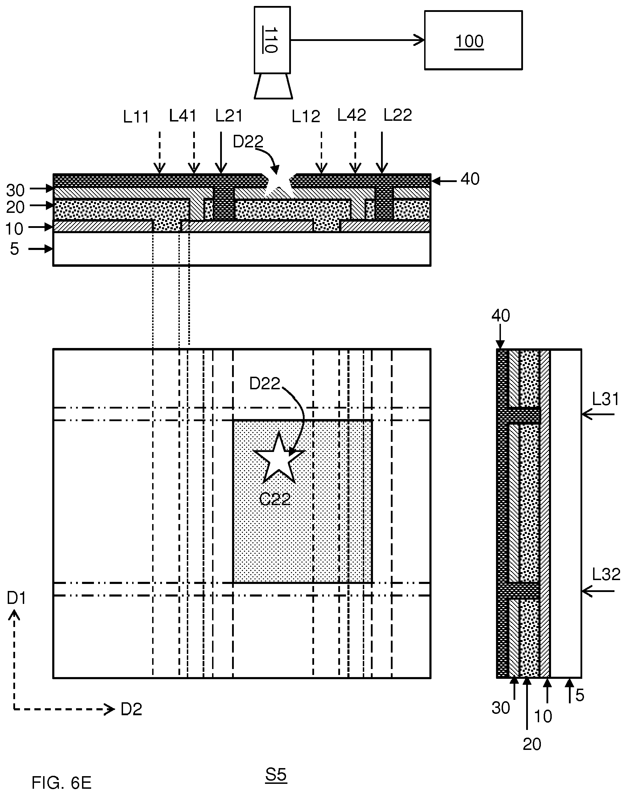

FIG. 6E shows an optional fifth step S5 of the manufacturing method,

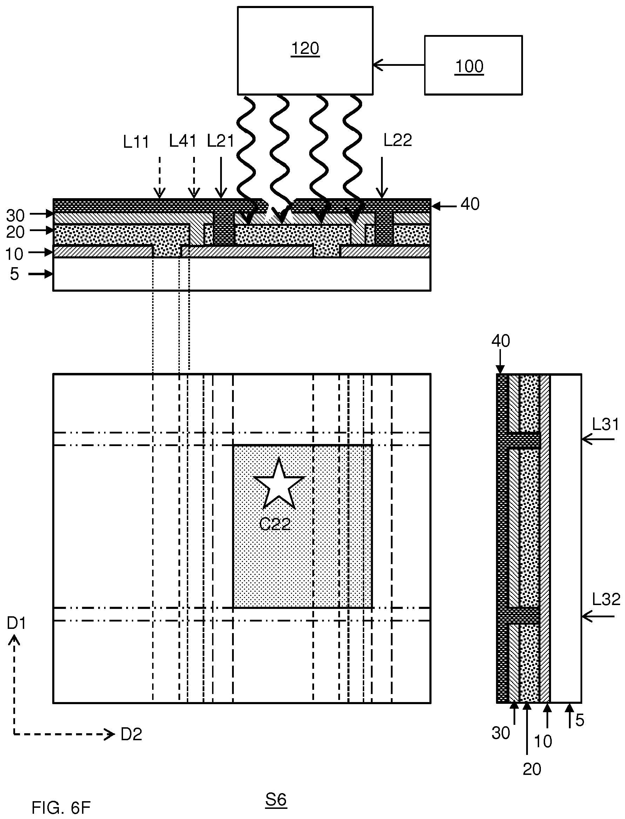

FIG. 6F shows an optional sixth step S6 of the manufacturing method;

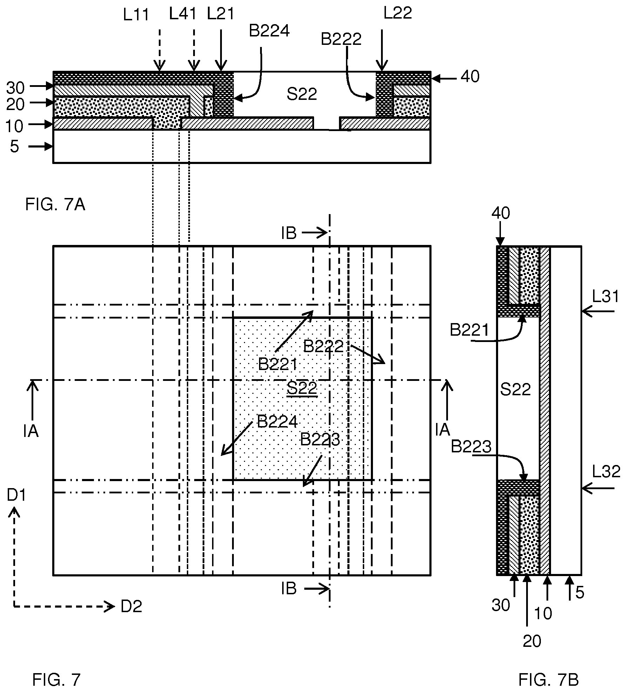

FIG. 7, 7A, 7B show a fifth embodiment of a photovoltaic panel according to the first object; therein FIG. 7 shows a top-view and FIG. 7A and 7B respectively show a cross-section according to VIIA-VIIA and VIIB-VIIB in FIG. 7.

### DETAILED DESCRIPTION OF EMBODIMENTS

Like reference symbols in the various drawings indicate like elements unless otherwise indicated.

FIG. 1, 1A, 1B schematically show a portion of a photovoltaic panel 1 that subsequently comprises a first electrically conductive layer 10, a photovoltaic layer 20 of a perovskite photovoltaic material and a second electrically conductive layer 30, and a protective coating 40 forming a barrier against moisture, arranged on a substrate 5. Therein FIG. 1 show a top-view of the photovoltaic panel 1 and FIG. 1A, and 1B respectively show a cross-section according to IA-IA in FIG. 1 and according to IB-IB in FIG. 1.

As shown in particular in FIG. 1A, and as also schematically illustrated in FIG. 1, the first electrically conductive layer 10 is partitioned into distinct portions along first partitioning lines L11, L12 extending in a first direction D1. In practice a width of the first partitioning lines may be in a range of 100 nm to 500 micron. Nevertheless additional partitions may be provided which are separated at larger distances, e.g. a few cm. A space formed by the first partitioning lines may be filled with a filling material different from a material of the first electrically conductive layer 10. The filling material may be the perovskite photovoltaic material of the photovoltaic layer 20. This is advantageous in that a separate filling step in the manufacturing process is superfluous. Alternatively an insulator may be used as the filler material, which has the advantage that the partitioning lines can be relatively narrow. A partitioning of a layer does not necessarily imply a removal of material from the layer. Alternatively it is possible to convert a layer along a partitioning line, for example an electrically conductive layer may be partitioned into mutually insulated areas by rendering the material non-conductive along partitioning lines that separate the mutually insulated areas. E.g. an electrically conductive layer of SnOF (FTO) can be rendered non-conducting by a laser heating step that transforms the material to SnO.

As also shown in FIG. 1A, and schematically illustrated in FIG. 1A, the second electrically conductive layer 30 and the photovoltaic layer 20 are partitioned along second partitioning lines L21, L22 extending in the first direction D1. The second electrically conductive layer 30 and the photovoltaic layer 20 are further partitioned along third partitioning lines L31, L32 that extend in a second direction D2 different from said first direction D1. In an embodiment the first and the second direction are mutually orthogonal, but alternatively, the directions D1, D2 may differ by another angle, e.g. an angle selected in the range of 10 to 90 degrees.

As can be seen in FIG. 1 and 1A, the first partitioning lines L11, L12 and the second partitioning lines L21, L22 alternate each other. Furthermore, a space 50 defined by the first partitioning lines L11, L12 and the third partitioning lines L31, L32 is filled with a protective filler material forming a barrier against moisture, therewith defining photovoltaic cells encapsulated by the protective material of the coating 40 and the protective filler material. In this embodiment the protective filler material in the space 50 is the same as the protective material of the coating. The protective material may for example comprise one or more of a ceramic material, such as SiN, Al2O3, TiO2, ZrO2. Also combinations are suitable, such as a combination of one of TiO2, ZrO2 with Al2O3. In manufacturing the protective material for the coating 40 and the space 50 may for example be provided in a single deposition process, e.g. by a CVD process or an (s)ALD process. In the embodiment shown the depth of the first partitioning lines L11, L12 and the third partitioning lines L31, L32 may for example be in the range of 100 nm to 200 micron, and a width may be in a range of 1 micron to 50 centimeter. In the embodiment shown fourth partitioning lines L41, L42 are provided in the direction D1, one between each first partitioning line and a subsequent second partitioning line. The fourth partitioning lines L41, L42 provide a space for an electrical connection between a portion of the second electrically conductive layer 30 defined by a cell (e.g. C12) and a portion of the first electrically conductive layer 10 defined by a neighboring cell (e.g. C22). A suitable width of this space is for example in the order of 40 to 80 micron. The electrical connection may be provided by the electrically conductive material of the second electrically conductive layer 30 onto a surface of the first electrically conductive layer 10, or by another electrically conductive material in the space provided by the fourth partitioning lines. Therewith a series arrangement is formed of the cells C11, C12, C13 arranged along the second direction D2. These are still connected by electrode 10 in this configuration.

As mention above, only a portion of the photovoltaic panel is shown in FIG. 1, 1A, 1B. In practice the panel may extend for example over a few meters in both directions D1, D2. It is also conceivable that the photovoltaic panel is provided as a foil based product on a roll. In that the panel may have a length in the range of a few tens of meters or even a few hundreds of meters. The cells may for example have dimensions in a range of a few mm to a few cm, or even larger.

In the embodiment shown, the photovoltaic panel 1 includes the substrate 5 as an additional layer. The substrate 5 may contribute to the encapsulation of the photovoltaic cells and provide for a mechanical reinforcement. In addition or alternatively, the substrate may serve as electrical conductor, to electrically connect one or both electrically conductive layers to external conductors. Mechanical reinforcement may for example be provided by a substrate layer of glass, a metal or a polymer. To serve as a moisture barrier, the substrate may for example include one or more barrier layers, e.g. including one or more inorganic layers, optionally alternated with an organic decoupling layer. To provide for electrical conduction, the substrate may for example comprise one or more metal layers, for example a par of metal layers arranged on mutually opposite sides of an insulating layer. A substrate layer may provide more than one of the above-mentioned functions. For example a glass layer may serve as a moisture barrier and provide for mechanical support, and a metal layer may provide for these functions and additionally serve as an electrical conductor. In an embodiment the first electrically conductive layer 10 may serve as a substrate. In that case an additional moisture barrier material may be provided in the spaces formed by the first partitioning lines L11, L12 etc. and/or as one or more barrier layers at a side of the first electrically conductive layer 10 opposite the photovoltaic layer 20. In a manufacturing process, the photovoltaic panel may for example be released from a carrier used during the manufacturing process, or such carrier may be dissolved at the end of the manufacturing process.

FIG. 2, 2A, 2B show an alternative embodiment of the photovoltaic panel. Therein FIG. 2 shows a top-view and FIG. 2A, and 2B respectively show a cross-section according to IIA-IIA in FIG. 2 and according to IIB-IIB in FIG. 2. This embodiment is provided with transverse electrically conductive elements T411,..,T41m,..,T41n; T421,..,T42m,..,T42n arranged between a respective first partitioning line L11; L12 and a respective subsequent second partitioning line L21; L22. The transverse electrically conductive elements electrically connect the second electrically conductive layer 30 with the first electrically conductive layer 10 and therewith are an alternative for the electrical connections as provided by the electrically conductive material in the spaces defined by the fourth partitioning lines in the embodiment of FIG. 1, 1A, 1B.

FIG. 3, 3A, 3B show a further alternative embodiment of the photovoltaic panel. Therein FIG. 3 shows a top-view and FIG. 3A, and 3B respectively show a cross-section according to IIIA-IIIA in FIG. 3 and according to IIIB-IIIB in FIG. 3.

In this embodiment one or more of the third partitioning lines L31, L32 extend through the first electrically conductive layer 10 and therewith also partition the first electrically conductive layer 10.

As set out above, FIG. 1 (A,B) and FIG. 2(A,B) present embodiments wherein one or more of the third partitioning lines L31, L32 have a depth bounded by the first electrically conductive layer 10.

In embodiments, a subset of the third partitioning lines may be provided as third partitioning lines L31, L32 that extend through the first electrically conductive layer 10 as shown in FIG. 3, 3A, 3B and another subset may be provided as third partitioning lines L31, L32 that have a depth bounded by the first electrically conductive layer 10 as shown in FIG. 1 (A,B) and FIG. 2(A,B).

It is advantageous if at least a subset of the third partitioning lines L31, L32 have a depth bounded by the first electrically conductive layer 10. Therewith mutually neighboring cells in the direction D1 can serve as a shunt for each other, should one of them be dysfunctional. This is schematically illustrated in FIG. 4A, 4B.

In FIG. 4A, the cells Cij of FIG. 1 or 2 are schematically indicated as by the symbol for a battery. The fourth partition lines L41, L42 are the locations where cells of a series arrangement are electrically interconnected by electrically conductive material of the second electrically conductive layer 20 that protrudes through the space defined these lines onto a surface of the first electrically conductive layer 10, or by another electrically conductive material in the space provided by the fourth partitioning lines. Alternatively an interconnection may be provided by transverse electrical conductors T411, ..,T41m,.., T41n, T421, ..,T42m,.., T42n, as shown in FIG. 2. FIG. 4A further schematically shows the third partitioning lines L31, L32, that extend in the second direction.

In operation photovoltaic currents I1, I2, I3 of substantially equal strength will flow in the second direction D2.

FIG. 4B schematically shows the situation wherein one of the cells, C22, is non-conducting. A current redistribution occurs wherein a current I2' originating from cell C21 of the middle branch is laterally distributed in the first electrically conductive layer 10, flows via the neighboring cells, e.g. C12, C32 and then returns to the cell C23 into the middle branch.

FIG. 5, 5A, 5B show a still further embodiment, therein FIG. 5 shows a top-view of the photovoltaic panel 1 and FIG. 5A, and 5B respectively show a cross-section according to VA-VA in FIG. 5 and according to VB-VB in FIG. 5.

In this embodiment one or more of the third partitioning lines L31, L32 extend through the first electrically conductive layer 10 and therewith also partition the first electrically conductive layer 10. This embodiment is provided with transverse electrically conductive elements T411,..,T41m,..,T41n; T421,..,T42m,..,T42n arranged between a respective first partitioning line L11; L12 and a respective subsequent second partitioning line L21; L22. The transverse electrically conductive elements electrically connect the second electrically conductive layer 30 with the first electrically conductive layer 10 and therewith are an alternative for the electrical connections as provided by the electrically conductive material in the spaces defined by the fourth partitioning lines in the embodiment of FIG. 1, 1A, 1B.

A method of manufacturing a photovoltaic panel of FIG. 1, 1A, 1B is now described with reference to FIG. 6A-6F.

Therein FIG. 6A shows a first step S1, wherein a first electrically conductive layer 10 is provided, that is partitioned along first partitioning lines L11, L12 extending in a first direction D1. In the embodiment shown, the partitioned first electrically conductive layer 10 is provided on a substrate 5, for example of a glass or a polymer. Also it may be contemplated to provide the first electrically conductive layer on a metal surface covered with an insulating layer.

The partitioned first electrically conductive layer 10 may be provided in a single step, for example by a masked deposition process, or by printing. Alternatively the partitioned first electrically conductive layer 10 may be provided in a first substep as a continuous layer, followed by a patterning process in a second substep, e.g. by etching, mechanical removal or by ablation with a laser. The lines may have a width w1 depending on further processing steps. For example, if the width w1 is substantially large, e.g. 1 micron or larger, a sufficient electrical insulation is provided by photovoltaic material to be applied in a subsequent step. A smaller width w1 is possible if an insulating material is provided into the removed regions of the first electrically conductive layer 10.

FIG. 6B shows a second step S2 wherein a photovoltaic layer 20 of a perovskite photovoltaic material is provided on the first electrically conductive layer 10. In FIG. 6B it is further shown that the perovskite photovoltaic material fills the spaces between the partitions of the first electrically conductive layer 10. The perovskite photovoltaic material therewith serves as an insulation between subsequent partitions in the direction D2.

FIG. 6C shows a third step S3, wherein a second electrically conductive layer 30 is provided that electrically contacts the first electrically conductive layer 10 near boundaries thereof defined by the first partitioning lines L11, L12. In the embodiment shown, the electric contacts are formed in that the photovoltaic layer 20 is partitioned by fourth partitioning lines L41, L42 that extend along the first partitioning lines in the first direction D1 and in that an electrically conductive material is allowed to penetrate through the spaces defined by the fourth partitioning lines L41, L42 onto the first electrically conductive layer and therewith form the electric contacts. Alternatively an electrically conductive material may be used that differs from the electrically conductive material of the second electrically conductive layer. Also, as an alternative electric contacts between the second electrically conductive layer 30 and the first electrically conductive layer 10 may be formed in an alternative step S3A, by transverse electrically conductive elements T411,..,T41m,..,T41n; T421,..,T42m,..,T42n through mutually distinct openings arranged near the boundaries of the first electrically conductive layer 10 defined by the first partitioning lines L11, L12, as is schematically indicated in FIG. 6CA. As in step S3, the openings serving to accommodate the electric connection between the first and the second electrically conductive layer may be provided in any manner. One option is to apply the photovoltaic layer 20 with a controlled deposition process, e.g. printing or deposition through a mask, wherein the openings are already defined in the deposition process. Alternatively the openings may be provided subsequent to the deposition process by a removal step, such as etching, and laser drilling or cutting.

FIG. 6D shows a fourth step S4, wherein a protective coating 40 is provided that at least forms a barrier against moisture, the protective material of the protective coating 40 protrudes into spaces defined by second partitioning lines L21, L22 extending in the first direction D1 and by spaces defined by third partitioning lines L31, L32 extending in the second direction D2 different from the first direction D1, in this case to the orthogonal direction. The first and the second partitioning lines alternate each other. Both the second electrically conductive layer 30 and the photovoltaic layer 30 are partitioned therewith. Therewith photovoltaic cells, e.g. C22, are defined that are encapsulated by the protective material of the protective coating 40.

In an alternative embodiment, the spaces defined by the third partitioning lines L31, L32, may extend partly or fully through the first electrically conductive layer 10.

In a further alternative embodiment a protective material may be provided into the spaces defined by the second and third partitioning lines L21, L22 L31, L32 before applying the protective coating, for example using a different protective material than the material used for the coating.

In an embodiment, the spaces defined by the second and third partitioning lines L21, L22 L31, L32 may be applied by a controlled deposition process of the second electrically conductive layer 30 and/or the photovoltaic layer 20, e.g. by printing or by a masked deposition method. Therewith the spaces are already formed in the deposition process. Alternatively the openings may be provided subsequent to the deposition process by a removal step, such as etching, and laser drilling or cutting. Also combinations are possible, for example the spaces in the photovoltaic layer 20 may be formed subsequent to its deposition and the spaces in the second electrically conductive layer may be formed in the deposition process.

In an optional subsequent step S5 as shown in FIG. 6E individual photovoltaic cells are inspected, for example all photovoltaic cells are inspected for example by inspection of camera images, for example obtained with a camera 110 and processed by a signal processing device 100. In the inadvertent case that a defect, e.g. D22 is found in a cell, the photovoltaic material contained therein is removed in a subsequent step S6, as shown in FIG. 6F. To that end the signal processing device 100 may have a data storage facility to store identification data for the defect cell, such as its coordinates on the photovoltaic panel or its row and column indices.

In the subsequent step S6 the photovoltaic material contained in the defect cell, e.g. C22, may be removed for example by treatment with a laser 120 controlled by the signal processing device 100. Also other means may be used. For example the material contained in the cell may be removed by mechanical interaction or by an etching step. If the defect is sufficiently large, the photovoltaic material contained in the defect cell, e.g. C22, may be removed by rinsing the cell with a liquid, such as water. Also the step of rinsing may be applied as an additional step, for example subsequent to the laser treatment step as shown in FIG. 6F.

Upon completion of step S6, a photovoltaic panel is obtained as shown in FIGs. 7, 7A, 7B. Therein FIG. 7 shows a top-view and FIG. 7A and 7B respectively show a cross-section according to VIIA-VIIA and VIIB-VIIB in FIG. 7. As becomes apparent from FIG. 7, 7A, 7B, the photovoltaic panel comprises a space S22 free from photovoltaic material. The space S22 is bounded by a wall B221, B222, B223, B224 of protective material to an area defined by a pair of mutually subsequent first partitioning lines L21, L22 and a pair of mutually subsequent third partitioning lines L31, L32.

## Claims

1. A photovoltaic panel (1) comprising in the order named
A first electrically conductive layer (10),
A photovoltaic layer (30) of a perovskite photovoltaic material,
A second electrically conductive layer (20),
a protective coating (40) that at least forms a barrier against moisture wherein the first electrically conductive layer (10) is partitioned along first partitioning lines (L11, L12) extending in a first direction (D1),
wherein the second electrically conductive layer (30) and the photovoltaic layer (20) are partitioned along second partitioning lines (L21, L22) extending in said first direction (D1) and along third partitioning lines (L31, L32) extending in a second direction (D2) different from said first direction (D1), wherein said first and said second partitioning lines alternate each other and wherein a space (50) defined by said first and third partitioning lines is filled with a protective filler material forming a barrier against moisture, therewith defining photovoltaic cells encapsulated by the protective material of the coating and the protective filler material.

2. The photovoltaic panel (1) according to claim 1, wherein the protective material of the coating and the protective filler material are the same.

3. The photovoltaic panel (1) according to claim 1 or 2, wherein the photovoltaic layer (20) is further partitioned by fourth partitioning lines (L41, L42) extending in the first direction (D1), respective fourth partitioning lines being provided between a respective first partitioning line and a respective subsequent second partitioning line, and wherein a material of the second electrically conductive layer (30) protrudes through spaces in the photovoltaic layer defined by the fourth partitioning lines (L41, L42) and electrically contacts the first electrically conductive layer (10).

4. The photovoltaic panel (1) according to claim 1 or 2, being provided with transverse electrically conductive elements (T411,..,T41m,..,T41n; T421,..,T42m,..,T42n;) arranged between a respective first partitioning line (L11; L12) and a respective subsequent second partitioning line (L21; L22), and which electrically connect the second electrically conductive layer (30) with the first electrically conductive layer (10).

5. The photovoltaic panel (1) according to one or more of the previous claims, wherein one or more of the third partitioning lines (L31, L32) extend through the first electrically conductive layer (10).

6. The photovoltaic panel (1) according to one or more of the previous claims, wherein one or more of the third partitioning lines (L31, L32) have a depth bounded by the first electrically conductive layer (10).

7. The photovoltaic panel (1) according to one or more of the previous claims, further comprising a space (S22) free from photovoltaic material that is bounded by a wall (B221, B222, B223, B224) of protective material to an area defined by a pair of mutually subsequent first partitioning lines (L11, L12) and a pair of mutually subsequent third partitioning lines (L31, L32).

8. The photovoltaic panel (1) according to one or more of the previous claims comprising a planarizing layer between the second electrically conductive layer (20) and the protective coating (40).

9. A method of manufacturing a photovoltaic panel (1) subsequently comprising
providing (S1) a first electrically conductive layer (10) that is partitioned along first partitioning lines (L11, L12) extending in a first direction (D1),
providing (S2) at least one photovoltaic layer (20) of a perovskite photovoltaic material, the at least one photovoltaic layer (20) being partitioned along second partitioning lines (L21, L22) extending in said first direction (D1),
providing (S3) a second electrically conductive layer (20) that electrically contacts said first electrically conductive layer (10) along fourth lines in said first direction (D1),
providing (S4) a protective material into spaces defined by second partitioning lines (L21, L22) extending in said first direction (D1), and by third partitioning lines (L31, L32) extending in a second direction (D2) different from said first direction and which spaces partition the second electrically conductive layer (20) and the photovoltaic layer (20), and wherein respective ones of the fourth lines are arranged between respective ones of the first partitioning lines (L11, L12) and respective nearest one of the second partitioning lines (L21, L22), and
providing (S4) a protective material as a protective coating layer (40) therewith providing a plurality of photovoltaic cells (C11,) having a respective encapsulated portion of the photovoltaic layer.

10. The method according to claim 9 wherein in the step of providing a protective material as a protective coating (40) the protective material is allowed to fill the spaces defined by the second partitioning lines (L21, L22) and the third partitioning lines (L31, L32).

11. The method according to claim 9 or 10, wherein the spaces defined by the third partitioning lines (L31, L32) abut onto a surface of the first electrically conductive layer.

12. The method according to one or more of claims 9-11, wherein the fourth lines in said first direction (D1) are fourth partitioning lines (L41, L42) defining spaces that abut onto a surface of the first electrically conductive layer (10) and wherein the material of the second electrically conductive layer (20) fills said spaces to electrically contact the first electrically conductive layer (10).

13. The method according to one or more of claims 9-11, wherein subsequent to the step of providing (S3) the second electrically conductive layer (20) but before a step of providing second partitioning lines (L21, L22) and third partitioning lines (L31, L32), further a planarizing layer is provided.

14. The method according to one or more of claims 9-13, further comprising the step (S5) of inspecting individual photovoltaic cells (C11,) of the plurality of photovoltaic cells.

15. The method according to claim 14, further comprising the step of removing (S6) photovoltaic material contained in a photovoltaic cell upon detection of a defect therein.
